# EUROPEAN PATENT APPLICATION

(11) **EP 4 138 530 A1**
(43) Date of publication of application: **22.02.2023**
(21) Application number: 21788770.2
(22) Date of filing: 08.04.2021
(51) Int. Cl.: H05K 7/20, H02M 3/00

(54) **CONVERTER MODULE**

(30) Priority: 14.04.2020 KR 20200045518
(71) Applicant: LG Innotek Co., Ltd., Seoul 07796 (KR)
(72) Inventor: JUNG, Jae Hoo, Seoul 07796 (KR); KIM, Geun Ho, Seoul 07796 (KR)
(74) Representative: DREISS Patentanwälte PartG mbB
(86) International application number: PCT/KR2021/004439
(87) International publication number: WO 2021/210849

(57) **Abstract**

A converter module according to an embodiment of the present invention comprises: a heat dissipation member of a plate shape, having a flow path therein; a first module arranged on one surface of the heat dissipation member; and a second module arranged on the other surface of the heat dissipation member, wherein the heat dissipation member is formed integrally with the flow path inserted therein.

## Description

### [Technical Field]

The present invention relates to a converter, and more particularly, to a converter module being formed integrally with the flow path inserted therein.

### [Background Art]

As electric devices of automobiles, engine electric devices (starting device, ignition device, and charging device) and lighting devices are common, but recently, as vehicles become more electronically controlled, most systems including chassis electric devices are becoming electric and electronic.

Various electrical components such as lamps, audio, heaters, and air conditioners installed in automobiles receive power from the battery when an automobile is stopped and receive power from the generator when driving, and at this time, the power generation capacity of the 14V power system is used as a typical power supply voltage.

Recently, along with the development of the information technology industry, various new technologies (motor-type power steering, Internet, and the like) for the purpose of increasing the convenience of automobiles are being adopted into vehicles, and in the future, the development of new technologies that can take full advantage of the current automobile system is expected to continue.

A hybrid electric vehicle (HEV), regardless of soft or hard type, is installed with a DC-DC converter (low voltage DC-DC converter) for supplying an electric load (12V). In addition, the DC-DC converter, which acts as a generator (alternator) of a general gasoline vehicle, supplies a voltage of 12V for the electric load by stepping down the high voltage of the main battery (usually a high voltage battery of 144V or more).

A DC-DC converter refers to an electronic circuit device that converts DC power of a certain voltage to DC power of another voltage, and is used in various fields such as TV sets and automotive electronics.

Existing DC-DC converters are formed by assembling various parts such as heat sinks, tubes, gaskets, covers, and screws to form a flow path for heat dissipation. By forming a flow path in an assembly type, the material cost increases, and there is a difficulty in securing a space for arrangement of package parts.

### [Detailed Description of the Invention]

### [Technical Subject]

The technical problem to be solved by the present invention is to provide a converter module being formed integrally with the flow path inserted therein.

The subjects of the present invention are not limited to the subjects mentioned above, and other subjects not mentioned will be clearly understood by those skilled in the art from the following description.

### [Technical Solution]

In order to solve the above technical problem, a converter module according to an embodiment of a first embodiment of the present invention comprises: a plate-shaped heat dissipation member having a flow path formed therein; a first module being disposed on one surface of the heat dissipation member; and a second module being disposed on the other surface of the heat dissipation member, wherein the heat dissipation member is formed integrally with the flow path inserted therein.

In addition, the flow path may be formed of a cooling pipe through which a refrigerant flows.

In addition, the flow path may include an inlet and an outlet communicating the outside and the inside of the heat dissipation member, and may be formed as a single line from the inlet to the outlet.

In addition, a refrigerant inlet through which refrigerant is introduced from the outside is disposed at the inlet, and a refrigerant outlet for discharging the refrigerant circulating in the flow path to the outside is disposed at the outlet, and the refrigerant inlet and the refrigerant outlet may be integrally formed with the flow path.

In addition, the flow path may be disposed within a predetermined distance from the position of the heating element of the first module or the heating element of the second module.

In addition, the first module and the second module may have no overlapping driving time during which driving overlaps, or may be less than or equal to a predetermined ratio or a predetermined time.

In addition, in the first module and the second module, the positions of the heating elements being disposed on each module may not correspond to each other.

In addition, the heat dissipation member may include a plurality of heat dissipation fins on at least one surface of the one surface and the other surface.

In addition, the heat dissipation fins may be formed on an outer surface of the first module or the second module.

In addition, the heat dissipation member may be formed by insert molding of a cooling pipe that forms the flow path.

### [Advantageous Effects]

According to embodiments of the present invention, it is possible to reduce the cost for manufacturing the heat dissipation member. In addition, by arranging the package module on both sides of the heat dissipation member, space can be utilized efficiently.

The effect according to the present invention is not limited by the contents exemplified above, and more various effects are included in the present specification.

### [Brief Description of Drawings]

FIG. 1 illustrates a converter module according to an embodiment of the present invention.
FIG. 2 is a view for explaining a process of heat dissipation in a converter module according to an embodiment of the present invention.
FIG. 3 is a view illustrating a flow path of a converter module according to an embodiment of the present invention.
FIG. 4 is a view illustrating a heat dissipation member being formed integrally with the flow path of the converter module inserted therein according to an embodiment of the present invention.
FIG. 5 is a view for explaining each configuration of a converter module according to an embodiment of the present invention.
FIG. 6 is a view illustrating a converter module according to another embodiment of the present invention.
FIG. 7 is a view for explaining each configuration of a converter module according to another embodiment of the present invention.

### [BEST MODE]

Hereinafter, preferred embodiments of the present invention will be described in detail with reference to the accompanying drawings.

However, the technical idea of the present invention is not limited to some embodiments to be described, but may be implemented in various forms, and within the scope of the technical idea of the present invention, one or more of the constituent elements may be selectively combined or substituted between embodiments.

In addition, the terms (including technical and scientific terms) used in the embodiments of the present invention, unless explicitly defined and described, can be interpreted as a meaning that can be generally understood by a person skilled in the art, and commonly used terms such as terms defined in the dictionary may be interpreted in consideration of the meaning of the context of the related technology.

In addition, terms used in the present specification are for describing embodiments and are not intended to limit the present invention.

In the present specification, the singular form may include the plural form unless specifically stated in the phrase, and when described as "at least one (or more than one) of A and B and C", it may include one or more of all combinations that can be combined with A, B, and C.

In addition, in describing the components of the embodiment of the present invention, terms such as first, second, A, B, (a), and (b) may be used. These terms are merely intended to distinguish the components from other components, and the terms do not limit the nature, order or sequence of the components.

And, when a component is described as being 'connected', 'coupled' or 'interconnected' to another component, the component is not only directly connected, coupled or interconnected to the other component, but may also include cases of being 'connected', 'coupled', or 'interconnected' due that another component between that other components.

In addition, when described as being formed or arranged in "on (above)" or "below (under)" of each component, "on (above)" or "below (under)" means that it includes not only the case where the two components are directly in contact with, but also the case where one or more other components are formed or arranged between the two components. In addition, when expressed as "on (above)" or "below (under)", the meaning of not only an upward direction but also a downward direction based on one component may be included.

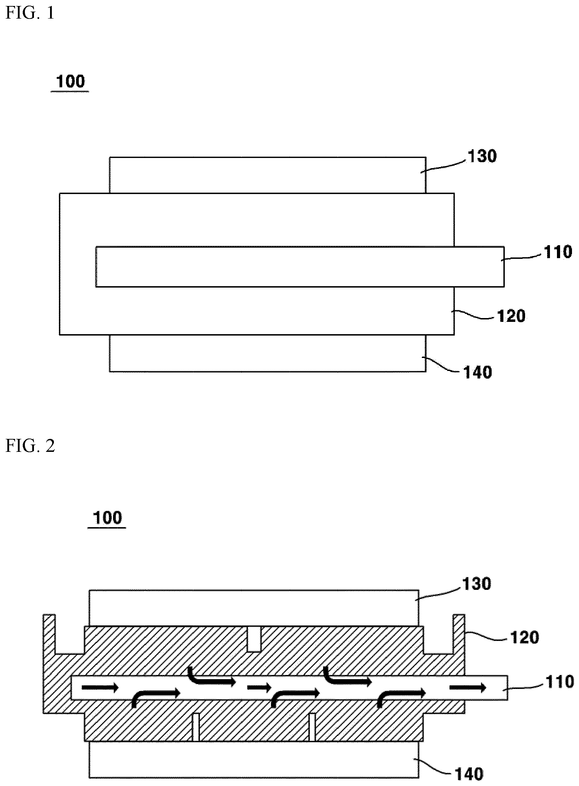

FIG. 1 illustrates a converter module according to an embodiment of the present invention.

The converter module **100** according to an embodiment of the present invention comprises a heat dissipation member **120** being formed with a flow path **110**, a first module **130**, and a second module **140**.

The heat dissipation member **120** is formed with a flow path **110** therein, and integrally formed with the flow path inserted therein.

More specifically, the heat dissipation member **120** is formed in a plate shape for dissipating the heat from the converter module **100** by radiating the heat generated in the converter module **100** to the outside. The heat dissipation member **120** may be a heat sink. A first module **130** and a second module **140** to perform heat dissipation are disposed on both sides of the heat dissipation member **120**. The first module **130** and the second module **140** are formed in a plate shape to be disposed on both surfaces. The heat dissipation member **120** radiates the heat being generated in the first module **130** and the second module **140** disposed on both surfaces toward the outside.

The heat dissipation member **120** uses refrigerant for heat dissipation. In order to perform heat dissipation using refrigerant, a flow path **110** through which refrigerant can flow is formed therein. The heat generated in the first module **130** and the second module **140** is transferred (conducted) to the flow path **110** through the heat dissipation member **120**, and the heat transferred to the flow path **110** is discharged to the outside along the flow path.

The heat dissipation member **120** is integrally formed by inserting the flow path **110** therein. The flow path **110** is formed in the shape to be formed, and when injecting a heat dissipation member **120**, it is injected while the flow path **110** is being inserted therein so that the heat dissipation member **120** being integrally formed with the flow path **110** therein can be formed. By forming the heat dissipation member **120** through injection in a state in which the flow path **110** is inserted, the number of required parts can be reduced than forming a flow path insertion type heat dissipation member as an assembly type.

The first module **130** is disposed on one surface of the heat dissipation member **120**, and the second module **140** is disposed on the other surface of the heat dissipation member **120**.

More specifically, the first module **130** and the second module **140** are modules included in the converter module **100**. For example, the first module **130** may be a DC-DC converter, and the second module **140** may be an on board charger (OBC).

A DC-DC converter is a device that converts a DC signal into a DC signal of a different magnitude. For example, a DC-DC converter used in a vehicle serves to supply the voltage for the load by stepping down the high voltage of the battery. For example, a DC-DC converter can convert a high voltage of 144V to a low voltage of 12V. The DC-DC converter comprises a transformer coil, an inductor, a switch, and the like for voltage conversion. In the process of converting voltage, a lot of heat is generated in devices such as switches implemented with FETs and the like. The heat dissipation member **120** dissipates heat generated in the heat generating element to the outside, thereby solving the problem of errors or low efficiency that may occur due to the temperature rise.

On board charger (OBC) is a device that boosts the voltage of an AC power and converts it into a DC power to charge a battery, and is used to charge a vehicle battery. In particular, it is used as an essential component for charging the battery of an electric vehicle. OBC also requires many components such as coils, inductors, and switches to perform voltage boosting and conversion, and a lot of heat is generated from the elements such as switches. The heat dissipation member **120** dissipates heat generated in the heating element constituting the OBC to the outside.

It is natural that various modules to be applied to the converter module **100** may be included other than the DC-DC converter or OBC.

The first module **130** and the second module **140** may be mounted on both surfaces of the heat dissipation member **120** to be disposed. They may be disposed in close contact with each other so that the heat generated in the first module **130** and the second module **140** can be well transferred to the heat dissipation member **120**. By arranging a plurality of modules on both sides of the heat dissipation member **120**, heat dissipation for the plurality of modules may be performed with one heat dissipation member **120**, thereby increasing the effect of heat dissipation and enhancing the degree of space utilization.

The first module **130** and the second module **140** may have no overlapping driving time, or may be less than or equal to a predetermined ratio or a predetermined time. Since the first module **130** and the second module **140** use one heat dissipation member **120**, for efficient heat dissipation, the first module **130** and the second module **140** may be controlled so that there is no overlapping driving time in which driving overlaps. When the first module **130** and the second module **140** are driven at the same time and a lot of heat is generated, heat dissipation may not be smoothly made for the two modules only with the heat dissipation performance of the heat dissipation member **120**, and as a result, a temperature rise may occur, which may result in malfunction or the like. Accordingly, in driving the first module **130** and the second module **140**, the first module **130** and the second module **140** may be controlled so that there is no overlapping driving time during which the driving overlaps. Or, even if there is an overlapping driving time, the overlapping driving time may be limited to a predetermined ratio or less than a predetermined time. By limiting the overlapping driving time, it is possible to increase the heat dissipation efficiency of the heat dissipation member **120**.

Here, the ratio of overlapping driving time means the ratio of overlapping driving time within a unit time. For example, if the threshold value limiting the rate of overlapping driving time is 10%, it can be limited to 6 minutes or less within 1 hour.

Or, the time in which the overlapping driving continues may be limited. For example, if the threshold value of the overlapping driving time is 10 minutes, the overlapping driving time may be limited to 10 minutes or less.

The threshold ratio or threshold time limiting the overlapping driving time may be preset by the user, or may vary depending on the heat dissipation performance of the heat dissipation member **120** or the temperature or external temperature of the current module, or the like.

The first module **130** and the second module **140** may be formed so that the positions of the heating elements disposed on each module do not correspond to each other. The first module **130** and the second module **140** may each include one or more heating elements, and when the heating elements of each module are disposed together in a specific region, heat in the corresponding region is greater than in other regions, and as a result, the efficiency of heat dissipation may be degraded. Accordingly, the heat dissipation efficiency can be increased by distributing the heating elements by forming the positions of the heating elements of the first module **130** and the positions of the heating elements of the second module **140** at different positions.

In disposing the first module **130** and the second module **140** in the heat dissipation member **120**, a module generating a lot of heat may be disposed on a lower surface of the heat dissipation member **120**. Since heat has tendency of being transferred from the bottom to the top, a module generating a lot of heat may be disposed on a lower surface for efficient heat dissipation through the heat dissipation member **120**.

In the converter module **100** being formed as shown in FIG. 2, the heat generated in the first module **130** and the second module **140** is transferred to the heat dissipation member **120** and discharged to the outside along the refrigerant flowing along the flow path **110** being formed inside the heat dissipation member **120**, thereby accomplishing heat dissipation. Both surfaces of the heat dissipation member **120** on which the module is disposed are formed in a plate shape, but a plurality of grooves may be formed for efficient heat transfer.

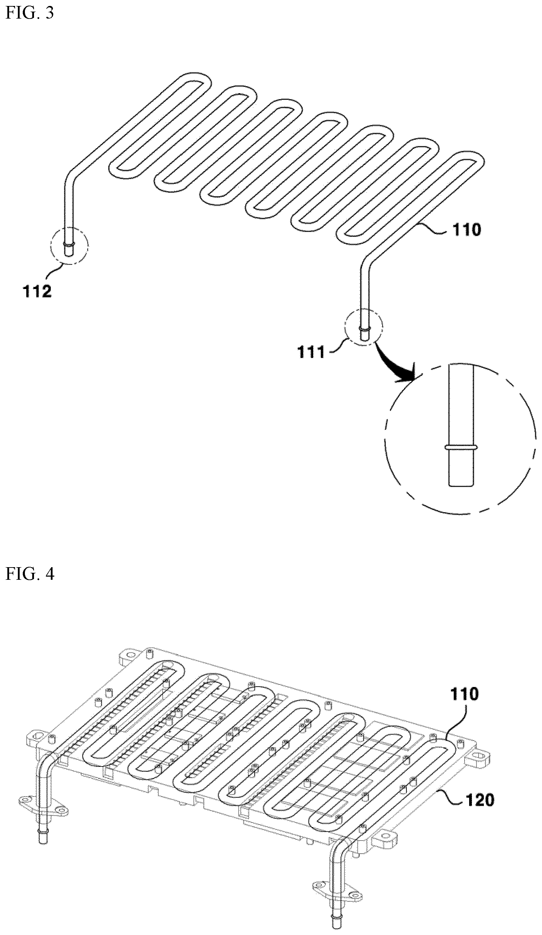

The flow path **110** formed in the heat dissipation member **120** may be formed as a cooling pipe through which refrigerant flows. The flow path **110** formed of the cooling pipe may include a plurality of straight parts and a plurality of bent parts connecting the straight parts, as shown in FIG. 3. The flow path **110** may be formed by bending a pipe having a constant diameter according to a designed shape.

The flow path **110** may be disposed within a predetermined distance from the location of the heating element of the first module **130** or the heating element of the second module **140**. In forming the flow path **110**, for efficient heat dissipation, the flow path **110** may be formed so that the flow path **110** passes within a predetermined interval with the heating element of the module. In FIG. 3, although the flow path **110** is only illustrated in a zigzag form, it may be formed in various forms depending on the location of the heating element.

The flow path **110** may include an inlet **111** and an outlet **112** communicating the outside and the inside of the heat dissipation member, and may be formed as a single line from the inlet **111** to the outlet **112**. As shown in FIG. 3, the flow path **110** is formed in a single line from the inlet **111** to the outlet **112**, and refrigerant introduced into the inlet **111** penetrates through the flow path **110** up to the outlet **112** and circulates, thereby discharging the heat being transferred toward the outside.

A refrigerant inlet through which refrigerant is introduced from the outside is disposed at the inlet **111**, and a refrigerant outlet for discharging the refrigerant circulated through the flow path **110** to the outside is disposed at the outlet **112**, The refrigerant inlet and the refrigerant outlet may be integrally formed with the flow path **110**. When refrigerant flows into the inlet **111** from the outside, sealing is required so that refrigerant does not leak out to the outside. At this time, when a sealing member is used for sealing, a separate part is required, and accurate sealing may be difficult due to a step difference between the products. In addition, if the material of the cooling pipe forming the flow path **110** and the part for sealing is different, when the temperature rises due to the dissipating heat, the expansion rate is different according to the temperature, so foreign substances or gaps may occur, which may cause a problem of sealing failure.

To solve this, the refrigerant inlet of the inlet **111** may be integrally formed with the flow path **110**. For sealing, it is necessary to have a stumbling block through which a contact member made of rubber or the like being formed on the external cooling hose can be in close contact. Sealing may be achieved by manufacturing the pipe of the inlet **111** portion to be formed with a stumbling block for sealing through the expansion and reduction process. A refrigerant outlet may also be formed and disposed at the outlet **112** through the piping process to correspond to the inlet **111**. By forming the refrigerant inlet and the cold outlet using a single pipe, it is possible to reduce the cost owing to a reduction in the number of parts, and by using the same material it is possible to prevent the problem of foreign substances from occurring due to the temperature difference.

The heat dissipation member **120** may be formed by insert molding of a cooling pipe forming the flow path. The heat dissipation member **120** is formed through molding, but by performing injection while the flow path **110** is inserted therein, an integrated heat dissipation member **120** having a flow path **110** formed therein may be formed. Insert molding is a process in which raw materials are melted and injected into the mold while objects to be inserted are still being inserted into the mold to produce parts, and it is also called die casting when it is made of metal. After forming the flow path **110** with the cooling pipe, as shown in FIG. 4, an integrated heat dissipation member **120** may be formed through insert molding while the cooling pipe is inserted into the mold. Through this, the heat dissipation member **120** can be integrally formed without a separate assembly process, and manufacturing cost can be reduced.

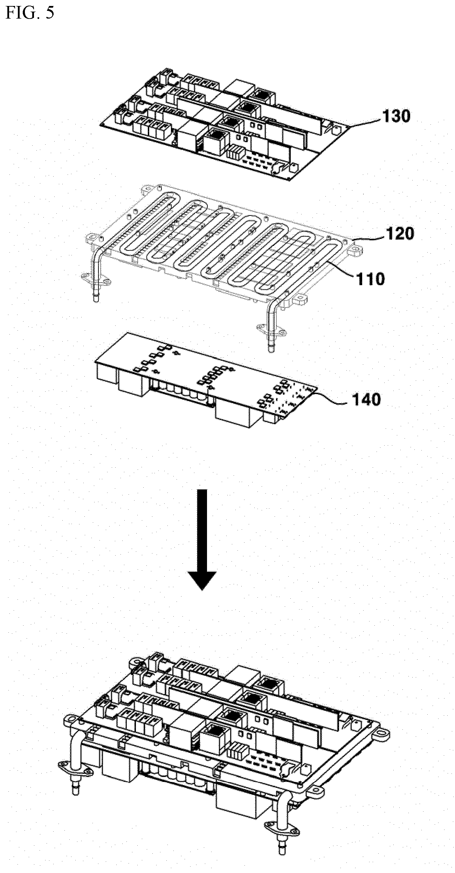

As shown in FIG. 5, the first module **130** and the second module **140** may be disposed on both surfaces of the heat dissipation member **120** formed as shown in FIG. 4. The first module **130** may be a DC-DC converter, the second module **140** may be an OBC, and each may be a package module formed by being mounted with components on a substrate. The first module **130** forming the DC-DC converter is disposed above the heat dissipation member **120**, and by mounting the second module **140** forming the OBC below the heat dissipation member **120**, one converter module **100** can be formed. Each module can be coupled a heat dissipation member using bolts and nuts.

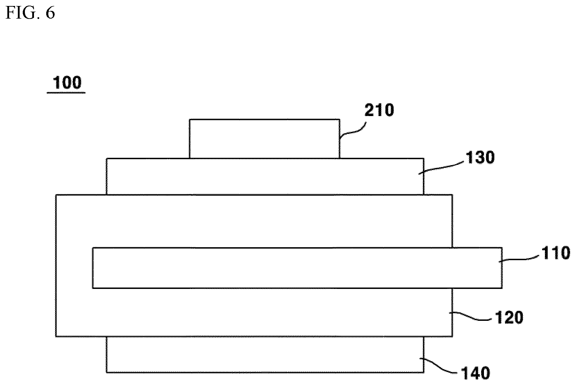

FIG. 6 is a view illustrating a converter module **100** according to another embodiment of the present invention, and may comprise a heat dissipation member **120** formed with a flow path **110**, a first module **130**, and a heat dissipation fin **210** together with the second module **140**. Since detailed descriptions of the flow path **110**, the heat dissipation member **120**, the first module **130**, and the second module **140** illustrated in FIG. 6 correspond to each configuration of the converter module **100** of FIGS. 1 to 5, overlapping descriptions will be omitted.

The heat dissipation fin **210** may be formed on at least one of one surface or the other surface of the heat dissipation member **120**. In the heat dissipation member **120** where the flow path **110** is formed, since modules are formed on both sides, the heat dissipation efficiency may be degraded compared to the case where the module is formed on only one side. To compensate for this, the efficiency of heat dissipation may be increased by using a plurality of heat dissipation fins **210**. The heat dissipation fins **210** may be formed on one or both surfaces of one surface or the other surface of the heat dissipation member. When forming a heat dissipation member on one surface, since heat has tendency of being transferred from the bottom to the top, by forming them on an upper surface of the heat dissipation member **120**, the heat being transferred upward through the heat dissipation fins **210** can be radiated to the outside.

At this time, the heat dissipation fins **210** may be formed on an outer surface of the first module **130** or the second module **140**. The surfaces of the first module **130** and the second module **140** in contact with the heat dissipation member **120** are heat-dissipated through the heat dissipation member **120**, and by forming the heat dissipation fin **210** on an outer surface not in contact with the heat dissipation member **120**, heat dissipation can be accomplished in both directions for the module in which the heat dissipation fin **210** is formed.

As previously described, heat has tendency of being transferred from the bottom to the top, and heat dissipation efficiency of the second module **140** being formed on a lower surface is higher than the first module **130** formed on an upper surface of the heat dissipation member **120**. Accordingly, the heat dissipation efficiency of the first module **130** with low heat dissipation efficiency can be increased by forming the heat dissipation fins **210** on an upper portion of the first module **130** with low heat dissipation efficiency, and the efficiency of heat dissipation radiated to the outside through the heat dissipation fins **210** may also be increased.

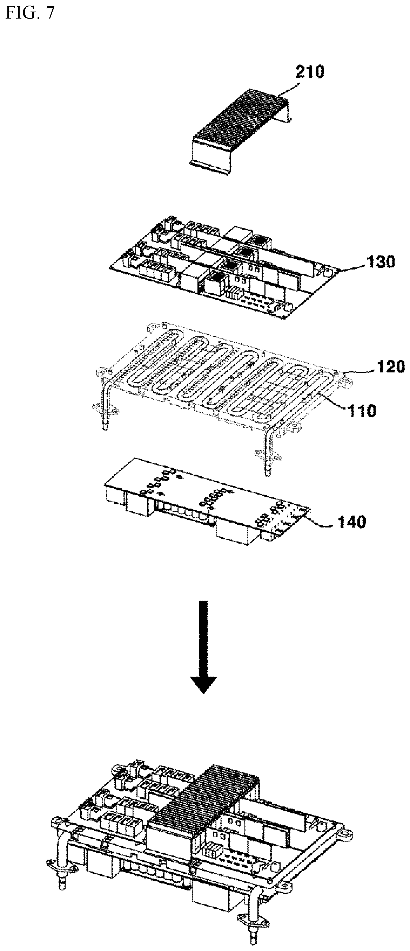

The heat dissipation fins **210** may be formed in the form of a cover of the first module **130** as shown in FIG. 7. The first module **130** is contact-coupled to cover the region where the heating element is disposed to transfer heat generated from the heating element of the first module **130** to the upper portion of the heat dissipation fin **210** and radiate it to the outside so that the heat dissipation is performed.

As described above, in the present invention, specific matters such as specific components, and the like; and limited embodiments and drawings have been described, but these are only provided to help a more general understanding of the present invention, and the present invention is not limited to the above embodiments, and various modifications and variations are possible from these descriptions by those of ordinary skill in the art to which the present invention belongs.

Therefore, the spirit of the present invention should not be limited to the described embodiments, and not only the claims to be described later, but also all those with equivalent or equivalent modifications to the claims will be said to belong to the scope of the spirit of the present invention.

## Claims

1. A converter module comprising:
a heat dissipation member formed of plate-shaped and having a flow path formed therein;
a first module disposed on one surface of the heat dissipation member; and
a second module disposed on the other surface of the heat dissipation member,
wherein the heat dissipation member is formed integrally with the flow path inserted therein.

2. The converter module according to claim 1,
wherein the flow path is formed of a cooling pipe through which a refrigerant flows.

3. The converter module according to claim 1,
wherein the flow path comprises an inlet and an outlet communicating outside and inside of the heat dissipation member, and is formed as a single line from the inlet to the outlet.

4. The converter module according to claim 3,
wherein a refrigerant inlet through which refrigerant is introduced from the outside is disposed at the inlet,
wherein a refrigerant outlet for discharging the refrigerant circulating in the flow path to the outside is disposed at the outlet, and
wherein the refrigerant inlet and the refrigerant outlet are integrally formed with the flow path.

5. The converter module according to claim 1,
wherein the flow path is disposed within a predetermined distance from a position of a heating element of the first module or a heating element of the second module.

6. The converter module according to claim 1,
wherein an overlapping driving time between the first module and the second module is none, or less than or equal to a predetermined ratio or a predetermined time.

7. The converter module according to claim 1,
wherein in the first module and the second module, positions of the heating elements being disposed on each module are not corresponding to each other.

8. The converter module according to claim 1,
wherein the heat dissipation member comprises a plurality of heat dissipation fins on at least one surface of the one surface and the other surface.

9. The converter module according to claim 8,
wherein the heat dissipation fins are formed on an outer surface of the first module or the second module.

10. The converter module according to claim 1,
wherein the heat dissipation member is formed by insert molding of a cooling pipe that forms the flow path.
